# EUROPÄISCHE PATENTSCHRIFT

(11) **EP 0 592 712 B1**
(45) Veröffentlichungstag und Bekanntmachung des Hinweises auf die Patenterteilung: **29.01.1997**
(21) Anmeldenummer: 92117567.5
(22) Anmeldetag: 14.10.1992
(51) Int. Cl.: H05K 7/14, H01R 13/629, H01R 13/645

(54) **Steckanschlusssystem für eine elektronische Baugruppe**
Plug connection system for an electronic assembly
Système de raccordement à fiche pour une assemblage électronique

(43) Veröffentlichungstag der Anmeldung: 20.04.1994
(73) Patentinhaber: SIEMENS AKTIENGESELLSCHAFT, 80333 München (DE)
(72) Erfinder: Meiler, Werner, W-8451 Ebermannsdorf (DE); Deinhardt, Günther, Dipl.-Ing. (FH), W-8450 Amberg (DE)

(56) Entgegenhaltungen:
- EP-A- 0 165 434
- EP-A- 0 392 629

## Beschreibung

Die vorliegende Erfindung betrifft einen Anschlußstecker nach dem Oberbegriff des Anspruchs 1 sowie eine Steckeraufnahme nach dem Oberbegriff des Anspruchs 13 und ein Steckanschlußsystem sowie eine elektronische Baugruppe, die einen solchen Anschlußstecker und eine solche Steckeraufnahme enthalten.

Ein gattungsgemäßer Anschlußstecker sowie eine hierzu korrespondierende Steckeraufnahme sind beispielsweise aus der EP-A-0 392 629 bekannt.

Die Aufgabe der vorliegenden Erfindung besteht darin, einen Anschlußstecker bzw. die korrespondierende Steckeraufnahme zur Verfügung zu stellen, mittels derer der Stecker mit geringem Aufwand derart an der Steckeraufnahme befestigbar ist, daß einerseits Kräfte auf die Steckeraufnahme abgeleitet werden, andererseits der Stecker noch nicht endgültig mit der Steckeraufnahme kontaktiert ist.

Die Aufgabe wird durch die kennzeichnenden Merkmale der Ansprüche 1 bzw. 13 gelöst. Ein Steckanschlußsystem und ein elektronische Baugruppe gemäß der Erfindung sind im Anspruch 28 bzw. 30 definiert.

Wenn eines der Riegelelemente, vorzugsweise das am Anschlußstecker angeordnete Steckerriegelelement, an einem Verriegelungsschieber angeordnet ist, der eine Handhabe aufweist und zwischen einer Verriegelungsstellung und einer Lösestellung beweglich in einem Gegenlager gelagert ist, ist der Anschlußstecker ohne Werkzeug mit der Steckeraufnahme verbindbar bzw. von der Steckeraufnahme lösbar.

Wenn der Verriegelungsschieber mittels im wesentlichen linearer Bewegungen, z.B. Verschieben, in sein Gegenlager einführbar ist, wobei der Verriegelungsschieber und die Steckeraufnahme bzw. der Anschlußstecker je ein Stoppelement aufweisen, so daß der Verriegelungsschieber unverlierbar in seinem Gegenlager gehalten ist, ist der konstruktive Aufbau des Verriegelungsschiebers besonders einfach.

Vorzugsweise ist der Anschlußstecker in einer der Stellungen, im folgenden Vorraststellung genannt, elektrisch von der Steckeraufnahme getrennt. Dadurch können die an den Anschlußstecker angeschlossenen Anschlußleitungen in der Vorraststellung in einfacher Weise durchgemessen werden.

Wenn die Steckeraufnahme zur Aufnahme des Anschlußsteckers einen zum Anschlußstecker hin offenen Längskanal mit mindestens einer Seitenwand aufweist und das an der Steckeraufnahme angeordnete Aufnahmenführungselement an der Seitenwand angeordnet ist, ist der Anschlußstecker mit der Steckeraufnahme besonders stabil verbindbar und wird darüber hinaus beim Einführen in die Steckeraufnahme besonders exakt geführt.

Die Stabilität der Verbindung von Anschlußstecker und Steckeraufnahme ist sowohl in der Vorrast- als auch in der Endraststellung, besonders hoch, wenn die Steckeraufnahme mindestens zwei Aufnahmerriegelelemente aufweist, die im Längskanal an den Enden des Längskanals angeordnet sind.

Wenn der Steckeraufnahme ein Aufnahmencodierelement und dem Anschlußstecker ein Steckercodierelement zugeordnet ist, und das Steckercodierelement im Anschlußstecker verrastbar und vom Aufnahmencodierelement lösbar haltbar ist, ist es möglich, die Codierung selbstcodierend auszugestalten.

Wenn das Steckercodierelement auf der der Steckeraufnahme zugewandten Unterseite des Anschlußsteckers und das Aufnahmencodierelement am Boden eines den Anschlußstecker aufnehmenden Längskanals angeordnet ist, läßt sich die Codierung besonders platzsparend am Anschlußstecker und an der Steckeraufnahme anordnen.

Weitere Vorteile und Einzelheiten ergeben sich aus der nachfolgenden Beschreibung eines Ausführungsbeispiels, anhand der Zeichnungen und in Verbindung mit den weiteren Unteransprüchen. Dabei zeigen:
FIG 1 eine Baugruppe mit Steckeraufnahme und Frontstecker,
FIG 2 die Codierelemente,
FIG 3 die Vorraststellung und
FIG 4 die Endraststellung des Frontsteckers.

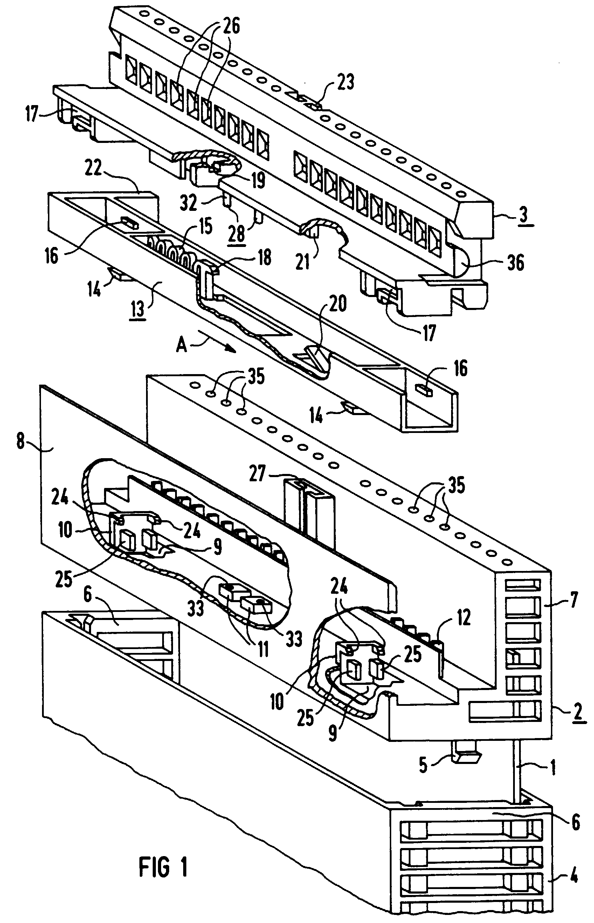

Gemäß FIG 1 weist die elektronische Baugruppe eine Leiterplatte 1 auf, auf der eine nicht dargestellte elektronische Schaltung realisiert ist. Die Schaltung kann z.B. derart sein, daß die Baugruppe als Digital-Eingabebaugruppe bzw. Digital-Ausgabebaugruppe einer speicherprogrammierbaren Steuerung verwendbar ist. Mit der Leiterplatte 1 ist frontseitig eine Steckeraufnahme 2 verbunden, die zur Aufnahme des Frontsteckers 3 dient.

Die Baugruppe der vorliegenden Erfindung ist eine gekapselte, kastenförmige Baugruppe. Beim Zusammenbau wird die Leiterplatte 1 daher in die Gehäusekapsel 4 eingeschoben und verrastet nach dem Einschieben mittels der Rasthaken 5, die an den Enden der Steckeraufnahme 2 angeordnet sind und von denen nur der vordere sichtbar ist, an den Stegen 6 der Gehäusekapsel 4.

Die Steckeraufnahme 2 weist gemäß FIG 1 eine Leiterplattenabdeckung 7 und eine Wand 8 auf. Die Leiterplattenabdeckung 7 und die Wand 8 bilden die Wände eines Längskanals. Der Längskanal weist an seinen Enden zwei Ausnehmungen 9 auf, in denen je ein Aufnahmenriegelelement 10 angeordnet ist. Weiterhin sind in der Mitte des Längskanals zwei nicht sichtbare Ausnehmungen im Boden des Längskanals angeordnet, in denen die Aufnahmencodierelemente 11 befestigt sind. Ferner befindet sich im Längskanal die Messerleiste 12, mittels derer der Frontstecker 3 mit der Leiterplatte 1 elektrisch verbindbar ist. Außerdem ist an der dem Längskanal zugewandten Seite der Leiterplattenabdeckung 7 in etwa in der Mitte des Längskanals ein linear führendes Führungselement 27, z.B. eine Schwalbenschwanzführung oder wie hier eine T-Nut, angeordnet.

Wie aus FIG 1 ersichtlich ist, sind dabei die Messer der Messerleiste 12 quer zum Längskanal angeordnet. Dadurch ist das benötigte Teilstück des Längskanals für eines der Kontaktmesser kürzer als wenn die Kontaktmesser in Richtung des Längskanals ausgerichtet wären. Der Frontstecker 3 kann daher kompakt gebaut werden. Darüber hinaus ist es möglich, die Kontaktmesser einzeln direkt, d. h. ohne Zwischenträger, auf der Leiterplatte 6 anzuordnen.

Der Frontstecker 3 weist einen Verriegelungsschieber 13 auf. Der Verriegelungsschieber 13 ist vorzugsweise einstückig ausgebildet. Der Frontstecker 3 und der Verriegelungsschieber 13 können beispielsweise als Spritzgußteile ausgebildet sein bzw. aus Spritzgußteilen bestehen.

Der Verriegelungsschieber 13 weist zwei Steckerriegelelemente 14 auf. Die Steckerriegelelemente 14 sind im vorliegenden Fall im wesentlichen kurze, quer zum Längskanal angeordnete Querrippen, die an einem Ende eine Einführschräge aufweisen.

Der Verriegelungsschieber 13 wird mit dem Frontstecker 3 auf folgende Art und Weise verbunden:

Zunächst wird die Feder 15, die vorzugsweise als Kunststoffeder ausgebildet ist, in den Verriegelungsschieber 13 eingelegt. Gegebenenfalls kann die Feder 15 auch an den Verriegelungsschieber 13 oder an den Frontstecker 3 angeformt sein. Sodann werden die Vorsprünge 16 des Verriegelungsschiebers 13 in die Nuten 17 des Frontsteckers 3 eingeführt.

Durch einfaches Verschieben des Verriegelungsschiebers 13 in Richtung des Pfeiles A kommt zunächst der Rasthaken 18 der Feder 15 mit der Ausnehmung 19 des Frontsteckers 3 in Eingriff. Diese Lage des Verriegelungsschiebers 13 entspricht der Stellung, in der die Feder 15 nicht vorgespannt ist. Wenn der Verriegelungsschieber 13 nun noch etwas weiter in Richtung des Pfeiles A verschoben wird, so schiebt sich das federnde Schieberstoppelement 20 über das Steckerstoppelement 21. Dadurch verrastet der Verriegelungsschieber 13 mit dem Frontstecker 3. Der Verriegelungsschieber 13 ist dadurch unverlierbar in den Nuten 17 gehalten.

Wenn der Verriegelungsschieber 13 nun losgelassen wird, so geht er aufgrund der Federwirkung entgegen der Richtung des Pfeiles A zurück, bis die Stoppelemente 20, 21 diese Bewegung stoppen. In dieser Stellung ist die Feder 15 nur wenig vorgespannt. Diese Stellung ist die Verriegelungsstellung des Verriegelungsschiebers 13. Durch Drücken auf die Handhabe 22 kann der Verriegelungsschieber 13 in Richtung des Pfeiles A bewegt werden, bis die Enden der Nuten 17 auch diese Bewegung stoppen. Diese Stellung ist die Lösestellung des Verriegelungsschiebers 13.

Aufgrund des einfachen konstruktiven Aufbaus von Frontstecker 3 und Verriegelungsschieber 13 sowie des einfachen Zusammenbaus mittels Verschieben ist der Frontstecker 3 nebst Verriegelungsschieber 13 sehr kostengünstig herstellbar sowie auch der Zusammenbau automatisierbar.

Das Verbinden des Frontsteckers 3 mit der Steckeraufnahme 7 geschieht auf folgende Art und Weise:

Die T-Schiene 23 des Frontsteckers 3 wird in die T-Nut 27 der Leiterplattenabdeckung 7 eingeführt. Mittels dieser Führungselemente wird der Frontstecker 3 zwangsweise lagerichtig in die Steckeraufnahme 2 eingeführt. Beim Einführen stoßen zunächst die Steckerriegelelemente 14 auf die angefasten Rasthaken 24. Weil sowohl die Rasthaken 24 als auch die Steckerriegelelemente 14 angeschrägt sind, wird die Feder 15 zusammengedrückt und der Verriegelungsschieber 13 in Richtung des Pfeiles A bewegt. Nach dem Passieren der Rasthaken 24 wird die weitere Bewegung des Frontsteckers 3 durch die Vorsprünge 25 gestoppt. Der Frontstecker 3 befindet sich jetzt in der Vorraststellung. In dieser Stellung ist ein leichtes Einführen von Anschlußleitungen in die Anschlußleitungseinführungsöffnungen 26 des Frontsteckers 3 möglich. Die beim Anschließen der (in FIG 1 nicht dargestellten) Anschlußleitungen auftretenden Kräfte werden in der Vorraststellung auf die Leiterplattenabdeckung 7 oder die Steckerriegelelemente 10 übertragen. Die Anschlußleitungen können dabei nach dem Anschließen mittels an sich bekannter Kabelbinder an einer der Befestigungslaschen 36 fixiert werden.

In der Vorraststellung ist der Frontstecker 3 von der Messerleiste 12 elektrisch getrennt. Dadurch werden Beschädigungen der Leiterplatte 1 und der auf ihr angeordneten Schaltung mit Sicherheit vermieden. Weiterhin ist ein leichtes Durchmessen der nicht dargestellten Anschlußleitungen möglich.

Um den Frontstecker 3 in die Endraststellung zu bringen, muß der Verriegelungsschieber 13 mittels Drückens der Handhabe 22 zunächst entriegelt werden. Sodann kann der Frontstecker 3 weiter in die Steckeraufnahme 2 eingeschoben werden. Nach dem Passieren der Vorsprünge 25 durch die Aufnahmeriegelelemente 14 verrastet der Frontstecker 3 aufgrund des Druckes der Feder 15 selbsttätig in der Endraststellung. Aus dieser Endraststellung kann der Frontstecker 3 durch erneutes Betätigen der Handhabe 22 gelöst werden.

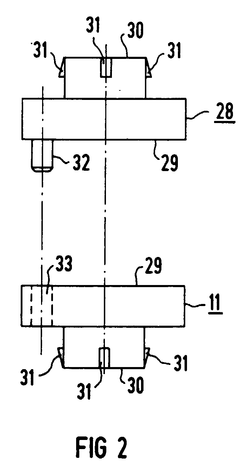

Wie obenstehend erwähnt, weist die Steckeraufnahme 2 zwei Aufnahmencodierelemente 11 auf, denen selbstverständlich korrespondierende Steckercodierelemente 28 am Frontstecker 3 gegenüberstehen. Mittels der Codierelemente 11, 28 wird erreicht, daß nur der "richtige" Frontstecker 3 mit der korrespondierende Steckeraufnahme 2 kontaktiert werden kann. Der prinzipielle Aufbau der Codierelemente 11, 28 ist in FIG 2 dargestellt. Gemäß FIG 2 bestehen die Codierelemente 11, 28 jeweils aus einem Grundkörper 29 und einem Rastvorsprung 30. Sowohl der Grundkörper 29 als auch der Rastvorsprung 30 haben einen quadratischen Querschnitt. In der Mitte der vier Seiten der Rastvorsprünge 30 sind kleine Rastnasen 31 angeordnet, mittels derer die Codierelemente 11, 28 in entsprechende Ausnehmungen der Steckeraufnahme 2 bzw. des Frontsteckers 3 einrasten können.

Aufgrund des quadratischen Querschnitts der Rastvorsprünge 30 sind vier Codierstellungen möglich. Ebenso sind aber auch andere Querschnitte mit z.B. 6 oder 8 Codierstellungen denkbar. Darüber hinaus sind die Rastvorsprünge 30 bei beiden Codierelementen 11, 28 gleich ausgebildet. Dadurch ist das Aufnahmencodierelement 11 auch in den Frontstecker 3 einsetzbar und das Steckercodierelement 28 auch in den Längskanal einsetzbar. Dadurch sind pro Codierpaar 11, 28 die doppelte Anzahl von Codierungen realisierbar.

Die Codierung geschieht im vorliegenden Fall durch einen an dem Steckercodierelement 28 asymmetrischen angeordneten Zapfen 32, der an seinem oberen Ende angefast ist. Der Zapfen 32 wird beim Einführen des Frontsteckers 3 in die Steckeraufnahme 2 in eine korrespondierende Bohrung 33 eingeführt, sofern die Codierung von Steckeraufnahme 2 und Frontstecker 3 übereinstimmen. Andernfalls verhindert der Zapfen 32 das Kontaktieren des Frontsteckers 3 mit der Messerleiste 12.

Vorzugsweise ist der Durchmesser der Bohrung 33 geringfügig kleiner als der Durchmesser des Zapfens 32, so daß die Codierelemente 11, 28 zwar mit geringem, nicht aber ohne Kraftaufwand ineinandergefügt und voneinander getrennt werden können. Dadurch wird nämlich ermöglicht, Steckeraufnahme 2 und Frontstecker 3 selbstcodierend auszugestalten. Dies geschieht auf folgende Weise:

Vor dem ersten Zusammenfügen von Steckeraufnahme 2 und Frontstecker 3 ist das Aufnahmencodierelement 11 bereits in den entsprechenden Ausnehmungen der Steckeraufnahme 2 verrastet. Der Zapfen 32 befindet sich in der Bohrung 33, so daß das Steckercodierelement 28 unverriegelt mit dem Aufnahmencodierelement 11 verbunden ist. Beim ersten Zusammenstecken von (noch uncodiertem) Frontstecker 3 und Steckeraufnahme 2 verrastet das Steckercodierelement 28 mittels der Rastnasen 31 auf der Unterseite des Frontsteckers 3. Dadurch wird der Frontstecker 3 codiert. Nach dem ersten Zusammenstecken von Frontstecker 3 und Steckeraufnahme 2 ist der Frontstecker 3 nur noch in diese Steckeraufnahme 2 bzw. eine Steckeraufnahme 2 mit gleicher Codierung einsteckbar. Ein versehentliches Zusammenstecken nicht zusammengehöriger Steckerteile wird daher mit an Sicherheit grenzender Wahrscheinlichkeit vermieden.

Sowohl die Codierung als solche als auch die Ausbildung der Codierelemente 11, 28 als selbstcodierende Codierelemente 11, 28 sind im Prinzip auch bei anderen Steckern, z.B. solchen mit Schwenkgelenk, einsetzbar. Dabei ist sowohl eine typspezifische Codierung der Baugruppen als auch eine anwendungsspezifische Codierung der Baugruppen realisierbar. Bei einer typspezifischen Codierung wird die Codierung der Baugruppen vom Hersteller der Baugruppen festgelegt, z.B. weisen 220 Volt-Eingabebaugruppen eine andere Codierung als 24-Volt-Ausgabebaugruppen auf. Bei anwendungsspezifischer Codierung liefert der Hersteller dem Anwender die uncodierte Baugruppe. Die Codierung kann dann vom Anwender entsprechend seinen Vorstellungen vorgenommen werden.

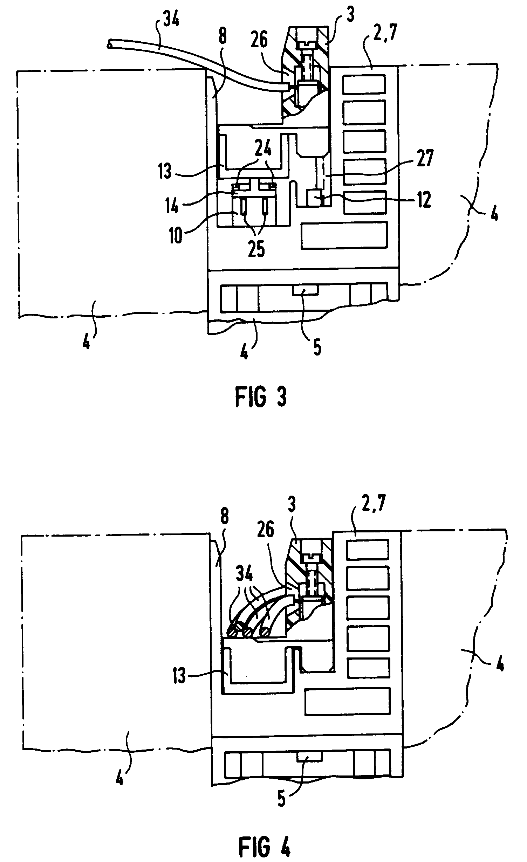

Anhand der Figuren 3 und 4 ist besonders deutlich ersichtlich, daß in der Vorraststellung die Anschlußleitungseinführungsöffnungen 26 leicht zugänglich sind, während in der Endraststellung der Frontstecker 3 und die Anschlußleitungen 34 vollständig innerhalb des Längskanals angeordnet sind. Dadurch ist es leicht möglich, die gesamte Baugruppe mit einer Abdeckung abzudecken, die typischerweise zugleich als Beschriftungsblende ausgebildet ist. Es ist beispielsweise möglich, an der Frontseite der Leiterplattenabdeckung 7 eine mit den Anschlußleitungseinführungsöffnungen 26 korrespondierende Reihe von Leuchtdioden 35 vorzusehen, so daß die über die Leuchtdioden 35 dargestellten Zustände den einzelnen Anschlußleitungen 34 besonders einfach zuordenbar sind. Wenn ferner auf der Beschriftungsblende für jede Leuchtdiode 35 eine Beschriftungszeile vorgesehen ist, ist die technologische Prozeßinformation für den Anwender besonders leicht und einfach erfaßbar.

## Patentansprüche

1. Anschlußstecker zum Anschließen von Anschlußleitungen (34) an eine elektronische Baugruppe durch Einführen des Anschlußsteckers (3) in eine der Baugruppe zugeordnete Steckeraufnahme (2), mit mindestens einem linear führenden Führungselement (23) zum lagerichtigen Führen des Anschlußsteckers (3) beim Einführen des Anschlußsteckers (3) in die Steckeraufnahme (2),
**dadurch gekennzeichnet**, daß der Anschlußstecker (3) mindestens ein Steckerriegelelement (14) zum lösbaren Verriegeln des Anschlußsteckers (3) in der Steckeraufnahme (2) aufweist, welches bei in die Steckeraufnahme (2) eingeführtem Anschlußstecker (3) mit einem an der Steckeraufnahme (2) angeordneten Aufnahmenriegelelement (10) zumindest in einer Vorraststellung und in einer Endraststellung zusammenwirkten kann.

2. Anschlußstecker nach Anspruch 1, **dadurch gekennzeichnet**, daß das Steckerriegelelement (14) an einem Verriegelungsschieber (13) angeordnet ist, der eine Handhabe (22) aufweist und zwischen einer Verriegelungsstellung und einer Lösestellung beweglich in einem Gegenlager (17) gelagert ist.

3. Anschlußstecker nach Anspruch 2, **dadurch gekennzeichnet**, daß der Verriegelungsschieber (13) mittels im wesentlichen linearer Bewegungen, z.B. Verschieben, in sein Gegenlager (17) einführbar ist und daß der Verriegelungsschieber (13) und der Anschlußstecker (3) je ein Stoppelement (20,21) aufweisen, so daß der Verriegelungsschieber (13) unverlierbar in seinem Gegenlager (17) gehalten ist.

4. Anschlußstecker nach Anspruch 2 oder 3, **dadurch gekennzeichnet**, daß dem Verriegelungsschieber (13) eine Feder (15) zugeordnet ist, mittels derer es bei Abwesenheit äußerer Einwirkungen in der Verriegelungsstellung gehalten ist.

5. Anschlußstecker nach Anspruch 4, **dadurch gekennzeichnet**, daß die Feder (15) in der Verriegelungsstellung des Verriegelungsschiebers (13) nur wenig vorgespannt ist.

6. Anschlußstecker nach einem der Ansprüche 2 bis 5, **dadurch gekennzeichnet**, daß der Verriegelungsschieber (13) einstückig ausgebildet ist, z.B. ein Spritzgußteil ist.

7. Anschlußstecker nach einem der obigen Ansprüche, **dadurch gekennzeichnet**, daß das Steckerriegelelement (14) eine Schräge aufweist, so daß der Anschlußstecker (3) beim Einführen in die Steckeraufnahme (2) selbsttätig mit der Steckeraufnahme (2) verrastet.

8. Anschlußstecker nach einem der obigen Ansprüche, **dadurch gekennzeichnet**, daß das Führungselement (23) an der Seite des Anschlußsteckers (3) angeordnet ist.

9. Anschlußstecker nach Anspruch 8, **dadurch gekennzeichnet**, daß das Führungselement (23) in etwa in der Mitte der Seite angeordnet ist.

10. Anschlußstecker nach Anspruch 8 oder 9, **dadurch gekennzeichnet**, daß der Anschlußstecker (3) mindestens zwei Steckerriegelelemente (14) aufweist, die an den Enden des Anschlußsteckers (3) angeordnet sind.

11. Anschlußstecker nach einem der obigen Ansprüche, **dadurch gekennzeichnet**, daß er mindestens eine Ausnehmung zur Aufnahme eines im Anschlußstecker (3) verrastbaren Codierelements (28) aufweist.

12. Anschlußstecker nach Anspruch 11, **dadurch gekennzeichnet**, daß die mindestens eine Ausnehmung auf der der Steckeraufnahme (2) zugewandten Unterseite des Anschlußsteckers (3) angeordnet ist.

13. Steckeraufnahme für einen Anschlußstecker, mit mindestens einem linear führenden Führungselement (27) zum lagerichtigen Führen des Anschlußsteckers (3) beim Einführen des Anschlußsteckers (3) in die Steckeraufnahme (2),
**dadurch gekennzeichnet**, daß die Steckeraufnahme (2) mindestens ein Aufnahmenriegelelement (10) zum lösbaren Verriegeln des Anschlußsteckers (3) in der Steckeraufnahme (2) aufweist, welches bei in die Steckeraufnahme (2) eingeführtem Anschlußstecker (3) mit einem an dem Anschlußstecker (3) angeordneten Steckerriegelelement (14) zumindest in einer Vorraststellung und in einer Endraststellung zusammenwirken kann.

14. Steckeraufnahme nach Anspruch 13, **dadurch gekennzeichnet**, daß das Aufnahmenriegelelement (10) an einem Verriegelungsschieber angeordnet ist, der eine Handhabe aufweist und zwischen einer Verriegelungsstellung und einer Lösestellung beweglich in einem Gegenlager gelagert ist.

15. Steckeraufnahme nach Anspruch 14, **dadurch gekennzeichnet**, daß der Verriegelungsschieber mittels im wesentlichen linearer Bewegungen, z.B. Verschieben, in sein Gegenlager einführbar ist, wobei der Verriegelungsschieber und die Steckeraufnahme (2) je ein Stoppelement aufweisen, so daß der Verriegelungsschieber unverlierbar in seinem Gegenlager gehalten ist.

16. Steckeraufnahme nach Anspruch 14 oder 15, **dadurch gekennzeichnet**, daß dem Verriegelungsschieber eine Feder zugeordnet ist, mittels derer es bei Abwesenheit äußerer Einwirkungen in der Verriegelungsstellung gehalten ist.

17. Steckeraufnahme nach Anspruch 16,
**dadurch gekennzeichnet**, daß die Feder in der Verriegelungsstellung des Verriegelungsschiebers nur wenig vorgespannt ist.

18. Steckeraufnahme nach einem der Ansprüche 14 bis 17, **dadurch gekennzeichnet**, daß der Verriegelungsschieber einstückig ausgebildet ist, z.B. ein Spritzgußteil ist.

19. Steckeraufnahme nach einem der Ansprüche 13 bis 18, **dadurch gekennzeichnet**, daß das Aufnahmenriegelelement (10) eine Schräge aufweist, so daß der Anschlußstecker (3) beim Einführen in die Steckeraufnahme (2) selbsttätig mit der Steckeraufnahme (2) verrastet.

20. Steckeraufnahme nach einem der Ansprüche 13 bis 19, **dadurch gekennzeichnet**, daß sie einen zum Anschlußstecker (3) hin offenen Längskanal mit mindestens einer Seitenwand (7) aufweist und daß das Führungselement (27) an der Seitenwand (7) angeordnet ist.

21. Steckeraufnahme nach Anspruch 20, **dadurch gekennzeichnet**, daß das Führungselement (27) in etwa in der Mitte der Seitenwand (7) angeordnet ist.

22. Steckeraufnahme nach Anspruch 20 oder 21, **dadurch gekennzeichnet**, daß sie mindestens zwei Aufnahmenriegelelemente (10) aufweist, die im Längskanal an den Enden des Längskanals angeordnet sind.

23. Steckeraufnahme nach einem der Ansprüche 13 bis 22, **dadurch gekennzeichnet**, daß sie ein Codierelement (11) aufweist.

24. Steckeraufnahme nach Anspruch 23, **dadurch gekennzeichnet**, daß das Codierelement (11) ein dem Anschlußstecker (3) zuzuordnendes Gegencodierelement (28) lösbar hält, welches beim Einführen des Anschlußsteckers (3) in die Steckeraufnahme (2) mit dem Anschlußstecker (3) verrastet.

25. Steckeraufnahme nach Anspruch 23 oder 24, **dadurch gekennzeichnet**, daß das Codierelement (11) am Boden eines den Anschlußstecker (3) aufnehmenden Längskanals verrastbar ist.

26. Steckeraufnahme nach Anspruch 25, **dadurch gekennzeichnet**, daß das Codierelement (11) in mehreren Stellungen mit der Steckeraufnahme (2) verrastbar ist.

27. Steckeraufnahme nach Anspruch 24 und einem der Ansprüche 25 und 26, **dadurch gekennzeichnet**, daß die Codierelemente (11,28) zum Verrasten in Steckeraufnahme (2) und Anschlußstecker (3) Rastvorsprünge (30) aufweisen und daß die Rastvorsprünge (30) gleich ausgebildet sind, so daß das Codierelement (11) auch als Gegencodierelement und das Gegencodierelement (28) auch als Codierelement verwendbar ist.

28. Steckanschlußsystem, insbesondere Frontsteckanschlußsystem, für eine elektronische Baugruppe, vorzugsweise eine gekapselte, kastenförmig ausgebildete elektronische Baugruppe, bestehend aus einem Anschlußstecker (3) nach einem der Ansprüche 1 bis 12 und einer Steckeraufnahme (2) nach einem der Ansprüche 13 bis 27.

29. Steckanschlußsystem nach Anspruch 28, **dadurch gekennzeichnet**, daß der Anschlußstecker (3) in einer der Stellungen elektrisch von der Steckeraufnahme (2) getrennt ist.

30. Elektronische Baugruppe, **dadurch gekennzeichnet**, daß sie ein Steckanschlußsystem nach einem der Ansprüche 28 oder 29 aufweist.

## Claims

1. Connection plug for connecting connecting lines (34) to an electronic module by inserting the connection plug (3) into a plug socket (2) which is associated with the module, having at least one linearly guiding guiding element (23) for guiding the connection plug (3), when inserting the connection plug (3) into the plug socket (2), into a correct position, characterised in that the connection plug (3) has at least one plug-locking element (14) for detachably locking the connection plug (3) in the plug socket (2), which element, when the connection plug (3) is inserted into the plug socket (2), can cooperate with a socket-locking element (10), which is arranged on the plug socket (2), at least in a pre-engaged position and in a final engaged position.

2. Connection plug according to claim 1, characterised in that the plug-locking element (14) is arranged on a locking slide (13) which has a handle (22) and is mounted in a counter-bearing (17) such that it can be moved between a locked position and a released position.

3. Connection plug according to claim 2, characterised in that the locking slide (13) can be inserted into its counter-bearing (17) by means of substantially linear movements, for example displacement, and in that the locking slide (13) and the connection plug (3) each have a stop element (20, 21) so that the locking slide (13) is held in its counter-bearing (17) such that it cannot become detached.

4. Connection plug according to claim 2 or 3, characterised in that associated with the locking slide (13) there is a spring (15) by means of which it is held in the locked position in the absence of external influences.

5. Connection plug according to claim 4, characterised in that the spring (15) is only pretensioned a little in the locked position of the locking slide (13).

6. Connection plug according to one of the claims 2 to 5, characterised in that the locking slide (13) is formed in one piece and is, for example, an injection-moulded portion.

7. Connection plug according to one of the above claims, characterised in that the plug-locking element (14) has a bevel so that the connection plug (3), when inserted into the plug socket (2), automatically engages with the plug socket (2).

8. Connection plug according to one of the above claims, characterised in that the guiding element (23) is arranged on the side of the connection plug (3).

9. Connection plug according to claim 8, characterised in that the guiding element (23) is arranged substantially in the centre of the side.

10. Connection plug according to claim 8 or 9, characterised in that the connection plug (3) has at least two plug-locking elements (14) which are arranged at the ends of the connection plug (3).

11. Connection plug according to one of the above claims, characterised in that it has at least one recess for the purpose of receiving a coding element (28) which can be engaged in the connection plug (3).

12. Connection plug according to claim 11, characterised in that the at least one recess is arranged on the underside of the connection plug (3) that faces the plug socket (2).

13. Plug socket for a connection plug, having at least one linearly guiding guiding element (27) for guiding the connection plug (3), when inserting the connection plug (3) into the plug socket (2), into a correct position, characterised in that the plug socket (2) has at least one socket-locking element (10) for detachably locking the connection plug (3) in the plug socket (2), which element, when the connection plug (3) is inserted into the plug socket (2), can cooperate with a plug-locking element (14), which is arranged on the connection plug (2), at least in a pre-engaged position and in a final engaged position.

14. Plug socket according to claim 13, characterised in that the socket-locking element (10) is arranged on a locking slide which has a handle and is mounted in a counter-bearing such that it can be moved between a locked position and a released position.

15. Plug socket according to claim 14, characterised in that the locking slide can be inserted into its counter-bearing by means of substantially linear movements, for example displacement, with the locking slide and the plug socket (2) each having a stop element so that the locking slide is held in its counter-bearing such that it cannot become detached.

16. Plug socket according to claim 14 or 15, characterised in that associated with the locking slide there is a spring by means of which it is held in the locked position in the absence of external influences.

17. Plug socket according to claim 16, characterised in that the spring is only pretensioned a little in the locked position of the locking slide.

18. Plug socket according to one of the claims 14 to 17, characterised in that the locking slide is formed in one piece and is, for example, an injection-moulded portion.

19. Plug socket according to one of the claims 13 to 18, characterised in that the socket-locking element (10) has a bevel so that the connection plug (3), when inserted into the plug socket (2), automatically engages with the plug socket (2).

20. Plug socket according to one of the claims 13 to 19, characterised in that it has a longitudinal channel, which is open towards the connection plug (3) and has at least one side wall (7), and in that the guiding element (27) is arranged on the side wall (7).

21. Plug socket according to claim 20, characterised in that the guiding element (27) is arranged substantially in the centre of the side wall (7).

22. Plug socket according to claim 20 or 21, characterised in that it has at least two socket-locking elements (10) which are arranged in the longitudinal channel at the ends of the longitudinal channel.

23. Plug socket according to one of the claims 13 to 22, characterised in that it has a coding element (11).

24. Plug socket according to claim 23, characterised in that the coding element (11) holds, in a detachable manner, a counter-coding element (28) which is to be associated with the connection plug (3) and which, when the connection plug (3) is inserted into the plug socket (2), engages with the connection plug (3).

25. Plug socket according to claim 23 or 24, characterised in that the coding element (11) can be engaged at the base of a longitudinal channel which receives the connection plug (3).

26. Plug socket according to claim 25, characterised in that the coding element (11) can be engaged with the plug socket (2) in a plurality of positions.

27. Plug socket according to claim 24 and one of the claims 25 and 26, characterised in that the coding elements (11, 28) have detent projections (30) for the purposes of engagement in the plug socket (2) and the connection plug (3), and in that the detent projections (30) are formed in an identical manner so that the coding element (11) can also be used as the counter-coding element, and the counter-coding element (28) can also be used as the coding element.

28. Plug and socket connection system, in particular a front plug and socket connection system, for an electronic module, preferably an encased electronic module which is formed in a box-like manner, the system consisting of a connection plug (3) according to one of the claims 1 to 12 and a plug socket (2) according to one of the claims 13 to 27.

29. Plug and socket connection system according to claim 28, characterised in that the connection plug (3) is electrically isolated from the plug socket (2) in one of the positions.

30. Electronic module, characterised in that it has a plug and socket connection system according to one of the claims 28 or 29.

## Revendications

1. Fiche de raccordement servant à raccorder des conducteurs (34) de raccordement à un module électronique en introduisant la fiche (3) de raccordement dans une réception (2) de fiche associée au module, comportant au moins un élément (23) de guidage linéaire pour guider la fiche (3) de raccordement à la bonne position lors de l'introduction de la fiche (3) de raccordement dans la réception (2) de fiche, caractérisé en ce que la fiche (3) de raccordement comporte au moins un élément (14) de verrouillage de fiche qui sert à verrouiller de manière amovible la fiche (3) de raccordement dans la réception (2) de fiche et qui, lorsque la fiche (3) de raccordement est introduite dans la réception (2) de fiche, peut coopérer avec un élément (10) de verrouillage de la réception (2) de fiche, au moins en une position de préencliquetage et en une position d'encliquetage final.

2. Fiche de raccordement suivant la revendication 1, caractérisé en ce que l'élément (14) de verrouillage de fiche est monté sur un coulisseau (13) de verrouillage qui comporte une manette (22) et qui est monté mobile entre une position de verrouillage et une position de déverrouillage dans une butée (17).

3. Fiche de raccordement suivant la revendication 2, caractérisé en ce que le coulisseau (13) de verrouillage peut être introduit dans sa butée (17) au moyen de déplacements sensiblement linéaires, par exemple d'un coulissement, et en ce que le coulisseau (13) de verrouillage et la fiche (3) de raccordement comportent chacun un élément (20, 21) de blocage, si bien que le coulisseau (13) de verrouillage est maintenu imperdable dans sa butée (17).

4. Fiche de raccordement suivant la revendication 2 ou 3, caractérisé en ce qu'il est associé au coulisseau (13) de verrouillage un ressort (15) au moyen duquel il est maintenu en la position de verrouillage en l'absence d'actions extérieures.

5. Fiche de raccordement suivant la revendication 4, caractérisé en ce que, en la position de verrouillage du coulisseau (13) de verrouillage, le ressort (15) n'est que peu précontraint.

6. Fiche de raccordement suivant l'une des revendications 2 à 5, caractérisé en ce que le coulisseau (13) de verrouillage est réalisé d'un seul tenant, par exemple en ce qu'il est une pièce moulée par injection.

7. Fiche de raccordement suivant l'une des revendications précédentes, caractérisé en ce que l'élément (14) de verrouillage de la fiche comporte un biseau, si bien que la fiche (3) de raccordement, lors de l'introduction dans la ré-ception (2) de fiche, s'encliquette automatiquement avec la réception (2) de fiche.

8. Fiche de raccordement suivant l'une des revendications précédentes, caractérisé en ce que l'élément (23) de guidage est monté sur le côté de la fiche (3) de raccordement.

9. Fiche de raccordement suivant la revendication 8, caractérisé en ce que l'élément (23) de guidage est monté à peu près au milieu du côté.

10. Fiche de raccordement suivant la revendication 8 ou 9, caractérisé en ce que la fiche (3) de raccordement comporte au moins deux éléments (14) de verrouillage de fiche qui sont montés aux extrémités de la fiche (3) de raccordement.

11. Fiche de raccordement suivant l'une des revendications précédentes, caractérisé en ce qu'il comporte au moins un évidement pour recevoir un élément (28) de codage qui peut être encliqueté dans la fiche (3) de raccordement.

12. Fiche de raccordement suivant la revendication 11, caractérisé en ce que le au moins un évidement est prévu sur la face inférieure de la fiche (3) de raccordement tournée vers la réception (2) de fiche.

13. Réception destinée à une fiche de raccordement, comportant au moins un élément (27) de guidage linéaire pour guider à la bonne position la fiche (3) de raccordement lors de l'introduction de fiche (3) de raccordement dans la réception (2) de fiche,
caractérisée en ce que la réception (2) de fiche comporte au moins un élément (10) de verrouillage de la réception qui sert à verrouiller de manière amovible la fiche (3) de raccordement dans la réception (2) de fiche et qui, lorsque la fiche (3) de raccordement est introduite dans la réception (2) de fiche, peut coopérer avec un élément (14) de verrouillage de la fiche prévu sur la fiche (3) de raccordement, au moins en une position de préencliquetage et en une position d'encliquetage final.

14. Réception de fiche suivant la revendication 13, caractérisée en ce que l'élément (10) de verrouillage de la réception est monté sur un coulisseau de verrouillage qui comporte une manette et qui est monté mobile entre une position de verrouillage et une position de déverrouillage dans une butée.

15. Réception de fiche suivant la revendication 14, caractérisée en ce que le coulisseau de verrouillage peut être introduit dans sa butée au moyen de déplacements sensiblement linéaires, par exemple d'un coulissement, le coulisseau de verrouillage et la réception (2) de fiche comportant chacun un élément de blocage, si bien que le coulisseau de verrouillage est maintenu imperdable dans sa butée.

16. Réception de fiche suivant la revendication 14 ou 15, caractérisée en ce qu'il est associé au coulisseau de verrouillage un ressort au moyen duquel il est maintenu en la position de verrouillage en l'absence d'actions extérieures.

17. Réception de fiche suivant la revendication 16, caractérisée en ce que, en la position de verrouillage du coulisseau de verrouillage, le ressort n'est que peu précontraint.

18. Réception de fiche suivant l'une des revendications 14 à 17, caractérisée en ce que le coulisseau de verrouillage est réalisé d'un seul tenant, par exemple en ce qu'il est une pièce moulée par injection.

19. Réception de fiche suivant l'une des revendications 13 à 18, caractérisée en ce que l'élément (10) de verrouillage de la réception comporte un biseau, si bien que la fiche (3) de raccordement, lors de l'introduction dans la réception (2) de fiche, s'encliquette automatiquement avec la réception (2) de fiche.

20. Réception de fiche suivant l'une des revendications 13 à 19, caractérisée en ce qu'elle comporte un canal longitudinal ouvert en direction de la fiche de raccordement et comportant au moins une paroi (7) latérale et en ce que l'élément (27) de guidage est disposé sur la paroi (7) latérale.

21. Réception de fiche suivant la revendication 20, caractérisée en ce que l'élément (27) de guidage est monté à peu près au milieu de la paroi (7) latérale.

22. Réception de fiche suivant la revendication 20 ou 21, caractérisée en ce qu'elle comporte au moins deux éléments (10) de verrouillage de la réception qui sont montés dans le canal longitudinal, aux extrémités du canal longitudinal.

23. Réception de fiche suivant l'une des revendication 13 à 22, caractérisée en ce qu'elle comporte un élément (11) de codage.

24. Réception de fiche suivant la revendication 23, caractérisée en ce que l'élément (11) de codage maintient de manière amovible un élément (28) de codage antagoniste, qui est à associer à la fiche (3) de raccordement et qui, lors de l'introduction de la fiche (3) de raccordement dans la réception (2) de fiche, s'encliquette avec la fiche (3) de raccordement.

25. Réception de fiche suivant la revendication 23 ou 24, caractérisée en ce que l'élément (11) de codage peut être encliqueté au fond d'un canal longitudinal recevant la fiche (3) de raccordement.

26. Réception de fiche suivant la revendication 25, caractérisée en ce que l'élément (11) de codage peut être encliqueté en plusieurs positions avec la réception (2) de fiche.

27. Réception de fiche suivant la revendication 24 et l'une des revendications 25 et 26, caractérisée en ce que les éléments (11, 28) de codage comportent pour l'encliquetage dans la réception (2) de fiche et dans la fiche (3) de raccordement, des saillies (30) d'encliquetage et en ce que les saillies (30) d'encliquetage sont réalisées de la même manière, si bien que l'élément (11) de codage peut être utilisé aussi comme élément de codage antagoniste et l'élément (28) de codage antagoniste aussi comme élément de codage.

28. Système de raccordement à enfichage, notamment système de raccordement à enfichage frontal, destiné à un module électronique, de préférence à un module électronique blindé, réalisé sous forme de boîte, constitué d'une fiche (3) de raccordement suivant l'une des revendications 1 à 12 et d'une réception (2) de la fiche suivant l'une des revendications 13 à 27.

29. Système de raccordement à enfichage suivant la revendication 28, caractérisé en ce que, en l'une des positions, la fiche (3) de raccordement est isolée du point de vue électrique de la réception (2) de fiche.

30. Module électronique, caractérisé en qu'il comporte un système de raccordement à enfichage suivant l'une des revendications 28 ou 29.
